# EUROPÄISCHE PATENTSCHRIFT

(11) **EP 1 456 891 B1**
(45) Veröffentlichungstag und Bekanntmachung des Hinweises auf die Patenterteilung: **30.05.2012**
(21) Anmeldenummer: 02798340.2
(22) Anmeldetag: 17.12.2002
(51) Int. Cl.: H01L 41/09

(54) **ABBILDUNGSEINRICHTUNG IN EINER PROJEKTIONSBELICHTUNGSANLAGE**
IMAGING DEVICE IN A PROJECTION EXPOSURE FACILITY
DISPOSITIF D'IMAGERIE OPTIQUE DANS UNE INSTALLATION D'ILLUMINATION PAR PROJECTION

(30) Priorität: 19.12.2001 DE 10162289; 07.06.2002 DE 10225266
(43) Veröffentlichungstag der Anmeldung: 15.09.2004
(73) Patentinhaber: Carl Zeiss SMT GmbH, 73447 Oberkochen (DE)
(72) Erfinder: HUMMEL, Wolfgang, 73447 Oberkochen (DE); FISCHER, Juergen, 89518 Heidenheim (DE); AUBELE, Karl-Eugen, 73312 Geislingen (DE); MERZ, Erich, 73457 Essingen (DE); RAOUL, Reiner, 75181 Pforzheim (DE); RIEF, Klaus, 73433 Aalen-Oberalfingen (DE); SCHOENGART, Stefan, 89044 Ulm (DE); NEUMAIER, Markus, 73450 Elchingen (DE); TROSSBACH, Baerbel, 73447 Oberkochen (DE); RASSEL, Thorsten, 74426 Buehlerzell (DE); WEBER, Ulrich, 89073 Ulm (DE); MUEHLBEYER, Michael, 73430 Aalen (DE); HOLDERER, Hubert, 89551 Koenigsbronn (DE); KOHL, Alexander, 73433 Aalen (DE); WEBER, Jochen, 89520 Grosskuchen (DE); LIPPERT, Johannes, 91592 Buch am Wald (DE)
(74) Vertreter: Lorenz, Werner
(86) Internationale Anmeldenummer: PCT/EP2002/014380
(87) Internationale Veröffentlichungsnummer: WO 2003/052511

(56) Entgegenhaltungen:
- EP-A1- 1 311 007
- EP-A2- 0 360 975
- DE-A1- 19 715 226
- US-A- 5 822 133
- US-A- 5 986 827
- US-A- 6 150 750

## Beschreibung

Die Erfindung betrifft eine Abbildungseinrichtung in einer Projektionsbelichtungsanlage für die Mikrolithographie mit wenigstens einem optischen Element und wenigstens einem einen Linearantrieb aufweisenden Manipulator zur Manipulation der Position des optischen Elements.

Bei derartigen Abbildungseinrichtungen für Projektionsbelichtungsanlagen in der Lithographie, kurz auch als Lithographieoptiken bezeichnet, ist es oft vorteilhaft, wenn einzelne optische Elemente während der Justage und/oder während des Betriebs aktiv positioniert werden können, um bestimmte Abbildungseigenschaften und Bildfehler genau einzustellen. So ermöglicht beispielsweise in rotationssymmetrischen Abbildungssystemen eine Verstellung von optischen Elementen unter Einhaltung der Rotationssymmetrie, z.B. bei rotationssymmetrischen refraktiven Objektiven das Verschieben von Linsen in Lichtrichtung (definiert in Richtung der z-Achse), die Beeinflussung des Fokus, des Abbildungsmaßstabes, der Verzeichnung 3. Ordnung, der Bildfeldwölbung, der linearen Koma und der konstanten sphärischen Aberration. Des weiteren können Umwelteinflüsse rotationssymmetrischer Natur, beispielsweise Änderung des atmosphärischen Umgebungsdrucks, des Innendrucks, der Luftfeuchtigkeit und der Temperatur inklusive longitudinaler Temperaturgradienten sowie rotationssymmetrischer Anteile der Linsenaufheizung korrigiert werden, wie aus US 4,961,001 und der DE 37 33 823 bekannt.
Bei rotationssymmetrischen Abbildungssystemen ermöglicht die Verstellung von optischen Elementen unter Aufhebung der Rotationssymmetrie und Herstellung einer einwelligen Symmetrie, z.B. bei rotationssymmetrischen refraktiven Objektiven das Verschieben von Linsen senkrecht zur z-Achse, nämlich in der x-y-Ebene, auch Linsendezentrierung genannt, oder das Verkippen von Linsen um Achsen senkrecht zur Lichtrichtung, die Beeinflussung von Zentrierfehlern, die sich in nicht rotationssymmetrischen Bildfehlerverläufen einwelliger Gesamtsymmetrie bezüglich Pupille und Feld ausdrücken. Darunter fallen z.B. Bildversatz, sagittale und tangentiale Verzeichnung 2. Ordnung, der lineare Bildschalenkipp und die konstante Koma. Des weiteren können Umwelteinflüsse einwelliger Symmetrie, z.B. Gradienten von Umgebungsdruck, Innendruck, Luftfeuchtigkeit und Temperatur senkrecht zur Lichtrichtung, korrigiert werden.

In katadioptrischen Lithographieoptiken mit ebenen Umlenkspiegeln oder Strahlteilerwürfeln ist es außerdem sehr vorteilhaft, die Umlenkspiegel- oder Strahlteilerflächen in ihrer Position und in ihren Kippwinkeln manipulieren zu können. Auch für konkave und konvexe Spiegelflächen in katadioptrischen oder katoptrischen Lithographieoptiken ist die Manipulation in den Translations- und Kippfreiheitsgraden geeignet, um rotationssymmetrische Bildfehler und Zentrierfehler genau einstellen zu können.

Derartige Abbildungseinrichtungen mit Manipulatoren sind dabei aus dem allgemeinen Stand der Technik bekannt.

Beispielhaft soll hier auf einen derartigen Manipulator anhand des in der US 5,822,133 beschrieben Aufbaus eingegangen werden. Der dortige Manipulator ist in den beschriebenen Anwendungsfällen als reiner z-Manipulator ausgebildet. Dies bedeutet, dass die Manipulation in Richtung der üblicherweise mit "z" bezeichneten optischen Achse erfolgt. Der Aufbau besteht aus zwei ineinander angeordneten ringförmigen Elementen, welche über verschiedene Ausführungsformen von Aktuatoren gegeneinander bewegt werden können. Zur Führung der Teile gegeneinander sind Blattfedern bzw. gemäß einer weiteren Ausgestaltung Membranen vorgesehen, welche für eine parallele Bewegung der beiden Teile gegeneinander sorgen sollen.

Ein derartiger Aufbau hat je nach Ausführungsform, insbesondere je nach Ausführungsform der verschiedenen beschriebenen Aktuatoren, jedoch entscheidende Nachteile. So ist beispielsweise bei der Verwendung von pneumatischen Aktuatoren nur eine vergleichsweise geringe Steifigkeit des Aufbaus zu erzielen. Bei einem entsprechenden Eintrag von Schwingungen sowie bei der Verwendung von sehr schweren optischen Elementen, beispielsweise die sehr großen Linsen, welche in der Mikrolithographie oder in astronomischen Anwendungen eingesetzt werden, führt diese geringe Steifigkeit des Manipulators zu gravierenden Nachteilen, welche sich auf die zu erzielende Abbildungsqualität sehr negativ auswirken.

In einer weiteren Ausgestaltung ist die Verwendung von hydraulischen Aktuatoren vorgeschlagen. Mit derartigen Aktuatoren ist sicherlich eine weitaus höhere Steifigkeit als mit den zuvor beschriebenen pneumatischen Aktuatoren zu erzielen. Die hydraulischen Aktuatoren bergen jedoch die Gefahr einer Kontamination der zu manipulierenden Bauteile mit der Hydraulikflüssigkeit, im allgemeinen einem Öl, im Falle einer Leckage in sich. Insbesondere bei Hochleistungsobjektiven, wie sie beispielsweise in der Mikrolithographie eingesetzt werden, ist eine derartige Kontamination mit Hydraulikflüssigkeit als gravierender Nachteil zu sehen. Derartige Objektive sind üblicherweise mit einem definierten Gasgemisch befüllt oder gegebenenfalls auch evakuiert. Sollte in diesen hochreinen Innenraum nun Hydraulikflüssigkeit, insbesondere Öl, gelangen, so kann dieses als Flüssigkeit oder Dampf in den Bereich der optischen Elemente gelangen und sich auf deren Oberfläche niederschlagen. Die Abbildungsqualität würde sich dann gravierend verschlechtern. Der Aufwand hinsichtlich einer eventuell möglichen Reinigung wäre extrem hoch.

Des weiteren sind in einer alternativen Ausführungsform der oben genannten Schrift entsprechende Aktuatoren aus Piezoelementen und Hebelgetrieben beschrieben. Die Hebel der Getriebe können dabei insbesondere über Festkörpergelenke miteinander verbunden sein. Diese Art von Aktuatoren können die beiden oben genannten Nachteile vermeiden. Mit diesen Aktuatoren lassen sich dabei auch recht gute Auflösungen erreichen. Allerdings weisen diese Aktuatoren den gravierenden Nachteil auf, dass sie nur einen sehr kleinen Verfahrweg ermöglichen. Je nach Anwendung, insbesondere in der oben bereits mehrfach erwähnten Verwendung in einer Abbildungseinrichtung für die Mikrolithographie, ist jedoch meist die Forderung nach sehr guten Auflösungen zusätzlich mit der Forderung nach einem sehr großen Verfahrweg im Verhältnis zu der möglichen Auflösung verbunden. Diese Erfordernisse, welche zum Erzielen einer sehr guten Abbildungsqualität häufig nicht zu vermeiden sind, können durch den Aufbau, welcher in der oben genannten US-Schrift beschrieben ist, nicht erzielt werden, so dass dieser die gewünschte Abbildungsqualität in nachteiliger Weise nicht ermöglicht.

Weitere Manipulatoren, welche jedoch die gleichen oder sehr ähnliche Nachteile aufweisen, sind beispielsweise durch die DE 199 10 947 A1 beschrieben. Diese Schrift zeigt einen Aufbau, bei welchem über Aktuatoren, z.B. Piezoelemente, und ein entsprechendes Getriebe aus über Festkörpergelenken verbundenen Hebeln, eine Bewegung des optischen Elements entlang der optischen Achse erreicht wird.

Eine Einrichtung zur Manipulation eines optischen Elements in einer Ebene senkrecht zu der optischen Achse ist z.B. durch die DE 199 01 295 A1 angegeben. Dabei sind wenigstens zwei Aktuatoren notwendig, welche aufgrund der mit diesen Aktuatoren zu erzielenden Bewegungsgenauigkeiten über aufwendige und komplexe Hebeleinrichtungen auf einen Innenring der Fassung, welcher das optische Element trägt, wirken. Um eine gleichmäßige und eine ausreichende Steifigkeit der Hebeleinrichtungen und damit der Anbindung der beiden Fassungsteile aneinander sowie eine hinreichende Auflösung der Bewegung zu gewährleisten, ist der Aufwand hinsichtlich der Fertigung, insbesondere hinsichtlich der Einhaltung von sehr engen Fertigungstoleranzen, erheblich.

Des weiteren ist aus der JP 3064372 eine Einrichtung zur Manipulation von optischen Elementen bekannt, wobei eine erste Gruppe optischer Elemente und eine zweite Gruppe optischer Elemente über einen Manipulator entlang einer optischen Achse verschiebbar angeordnet sind. Diese zwei optischen Gruppen können auch mit Hilfe der Manipulatoreinrichtung eine Kippbewegung zur optischen Achse ausführen. Für die Antriebe können elektrostriktive oder magnetostriktive Elemente eingesetzt werden. Die Ausführung der Drehaktuatoren ist in dieser Schrift nicht direkt eindeutig offenbart.

Zum weiteren Stand der Technik soll noch auf das US-Patent 6,150,750 verwiesen werden, welches einen Linearantrieb für den Bereich der Elektrotechnik, Telekommunikationstechnik und der Automatisierungstechnik zeigt. Der Linearantrieb weist einen angetriebenen Teilbereich und einen nicht angetriebenen Teilbereich auf, die relativ zueinander in Richtung einer Bewegungsachse beweglich sind, wobei die Teilbereiche über piezoelektrische Elemente, welche teilweise als Hubpiezos und teilweise als Scherpiezos ausgebildet sind, zumindest zeitweise miteinander verbunden sind. Durch die Hubpiezos können die einzelnen Piezostacks, welche jeweils Hub- und Scherpiezos umfassen, in Reibschluss zu dem angetriebenen Teilbereich gebracht oder von diesem abgehoben werden. Über die Scherpiezos derjenigen Stacks, welche in reibendem Eingriff sind, kann dann die eigentliche Bewegung realisiert werden. Danach ist ein Umgreifen auf andere Stacks denkbar, so dass sehr große Bewegungshübe realisiert werden können.

Weitere Beispiele für piezoelektrische Antriebe sind aus der europäischen Patentanmeldung EP 0 360 975 A2 und der deutschen Patentanmeldung DE 197 15 226 A1 bekannt.

Ferner ist aus der nach veröffentlichten europäischen Patentanmeldung EP 1 311 007 A1 ein piezoelektrischer Linearantrieb bekannt, bei welchem eine zwischen einer Mehrzahl von Piezostacks angeordnete Platte in einer Ebene bewegt werden kann.

Durch diesen Aufbau der Linearantriebe entsteht praktisch ein Aktuator, welcher in der Lage ist, über seine Piezoelemente Haltekräfte und Kräfte in Richtung der Bewegungsachse auf die beiden Teile des Linearantriebs auszuüben. Damit lässt sich ein linearer Stepper realisieren, welcher, je nach Wahl der Piezoelemente über eine sehr gute Auflösung und aufgrund der Möglichkeit des Umgreifens auch über einen sehr großen Bewegungsspielraum verfügt.

Es ist nun die Aufgabe der Erfindung eine Abbildungseinrichtung für eine Projektionsbelichtungsanlage in der Mikrolithographie mit einem Manipulator zu schaffen, welcher eine sehr steife Ausgestaltung und bei den durch den Manipulator auszuführenden Bewegungen, ein sehr gutes Verhältnis von Auflösung zu Hub ermöglicht.

Erfindungsgemäß wird diese Aufgabe durch eine Abbildungseinrichtung gemäß Anspruch 1 gelöst.

Durch den Aufbau des Manipulators mit dem oben beschriebenen Linearantrieb, ergibt sich ein idealer Manipulator für die Mikrolithographie. Dabei spielt es keine Rolle, in welche Richtung die Manipulation erfolgen soll, und wie viele von den Linearantrieben in dem Manipulator eingesetzt werden. Die vorteilhaften Eigenschaften ergeben sich aus der Art der Linearantriebe an sich.

So sind mit dem Aufbau beispielsweise sehr hohe Auflösungen, je nach eingesetzten Funktionselementen bis zu einigen Bruchteilen von Nanometern denkbar, wobei durch die Möglichkeit eines Umgreifens während der Bewegung des Linearantriebs auch ein sehr großer Bewegungsumfang, (Range) realisiert werden kann. Dabei sind Verhältnisse von Auflösung zu Range in der Größenordnung von 1 : 75.000 oder besser denkbar.

Diese idealen Eigenschaften sind verbunden mit einer sehr hohen Verstellgeschwindigkeit von mehr als 5µm/s bei gleichzeitig sehr hoher möglicher Verstellkraft von mehr als 100 N.

Der Aufbau der Linearantriebe selbst erlaubt bereits eine sehr hohe Steifigkeit. Aufgrund der Tatsache, dass auf ein Getriebe häufig verzichtet werden kann, lässt sich die Steifigkeit oftmals noch weiter steigern.

Dies alles funktioniert dabei beinahe ohne Wärmeentwicklung durch den Linearantrieb (Q < 10 mW). Beim Einsatz im Bereich von Abbildungseinrichtungen für die Mikrolithographie stellt dies einen besonderen Vorteil dar, da durch Wärmeentwicklung und die damit verbundene thermische Ausdehnung große Probleme hinsichtlich der Maßhaltigkeit und der zu erzielenden Genauigkeit entstehen können.

Des weiteren weisen die Linearantriebe eine sehr hohe Lebensdauer und einen sehr kleinen Bauraum bei den genannten Randbedingungen auf.

Gemäß einer besonders vorteilhaften Weiterbildung der Erfindung sind die Funktionselemente als piezoelektrische Elemente ausgebildet.

Ein derartiger Piezo-Linearantrieb kann dabei die sehr hohen und komplexen Anforderungen, welche durch die eingangs erwähnten Lithographieoptiken gestellt werden, ideal erfüllen.

Aufgrund der einmal als Scherpiezos und einmal als Hubpiezos ausgebildeten Funktionselemente ergibt sich die Möglichkeit einer sehr genauen Zustellung bei haltenden Hubpiezos über die prinzipbedingt hohe Auflösung der Scherpiezos. Die typischerweise geforderten Stellgenauigkeiten im Bereich von einigen Hundertsteln Nanometern bis einigen Nanometern, sind damit zu erzielen. Durch die Möglichkeit den Linearantrieb im Stepmodus zu betreiben sind auch die typischen Verfahrwege am optischen Element in der Größenordnung einiger 10 bis 100 µm problemlos zu erreichen. Durch die Zusammensetzung des gesamten verfahrenen Weges aus lauter einzelnen Teilen mit der oben angegebenen Genauigkeit, liegt auch die Genauigkeit des gesamten verfahrenen Weges in der oben genannten. Größenordnung. Die Piezo-Linearantriebe erreichen so das sich aus dem Bereich der einzustellenden Bildfehler und der geforderten Einstellgenauigkeit ergebende Verhältnis des maximalen Verfahrwegs zur notwendigen mechanischen Positioniergenauigkeit in der Größenordnung von 10⁵ bis 10⁷.

Aus den Massen der zu manipulierenden optischen Elemente und ihren Fassungen ergeben sich benötigte Stellkräfte in der Größenordnung von 10 bis 100 N und Haltekräfte unter Schockbelastung, beispielsweise beim Transport, die bis zu einer Größenordnung höher sein können. Mittels der Piezo-Linearantriebe lassen sich diese Halte- und Stellkräfte ebenso erreichen, wie eine sehr hohe Steifigkeit in Verstellrichtung. Diese hohe Steifigkeit, welche je nach Einsatzzweck von einigen N/µm bis zu einigen 100 N/µm reicht, ermöglicht es in besonders vorteilhafter Weise eine mechanische Eigenfrequenzen der optischen Elemente von einigen Hundert Hertz zu erzielen.

Aufgrund des sehr hohen Verhältnisses von maximalem Verfahrweg zur notwendigen mechanischen Positioniergenauigkeit der Piezo-Linearantriebe können diese in besonders günstiger Weise einen getriebelosen Aufbau haben. Damit lässt sich ein Umkehrspiel vermeiden oder zumindest minimieren und parasitäre Bewegungen in den Richtungen senkrecht zu der gewünschten Bewegungsrichtung können unterdrückt werden.

Um dies in idealer Weise realisieren zu können muss der Antrieb möglichst nah am optischen Element angeordnet sein, was wiederum den zur Verfügung stehenden Bauraum erheblich einschränkt. So ist beispielsweise bei refraktiven Systemen eine vollständige Integration des Antriebs in die zylindrische Außenkontur des Objektivs vorteilhaft. Durch den prinzipbedingt sehr kleinen möglichen Aufbau der Piezo-Linearantriebe betragen die Abmessungen jedes einzelnen Antriebs in jeder Richtung nur wenige Zentimeter. Die Integration ist damit in besonders günstiger Weise leicht möglich.

Aus der Integration des Piezo-Linearantriebs in die Linsenfassung ergibt sich außerdem die Forderung nach einer geringen Wärmeentwicklung, da thermische Ausdehnungen und Spannungen im Bereich der optischen Elemente unbedingt vermieden werden müssen, um die im Bereich der Mikrolithographie erforderliche entsprechend hohe Abbildungsqualität zu erreichen. Durch die bei Piezoelementen bekannt niedrige Wärmeentwicklung lassen sich in jedem der Piezo-Linearantriebe Wärmeentwicklungen von weniger als 10 mW realisieren. Die Integration des Piezo-Linearantriebes in die Abbildungseinrichtung im Bereich der optischen Elemente stellt damit also auch unter diesem Gesichtspunkt kein Problem dar.

Typischerweise werden im Bereich der Lithographieoptiken für Verstellungen zwischen einzelnen Belichtungen Verstellgeschwindigkeiten von einigen µm/s gefordert. Da die Scherpiezos sehr schnell reagieren können, kann diesen Anforderungen nachgekommen werden, da die Verstellungen üblicherweise mit so kleinen Verstellwegen erfolgen, dass der Analogmodus der Piezo-Linearantriebe, also die reine Verstellung über die Scherpiezos ohne ein Anheben bzw. Absenken der Hubpiezos, hierfür ausreicht.

Über die gesamte Lebensdauer eines Systems von mehr als 10 Jahren wird hingegen der gesamte Verfahrbereich benötigt. Dies ist mit den Piezo-Linearantrieben zu erreichen, da diese in vorteilhafter Weise ihre Position an einem Ende des Verfahrbereichs halten können, ohne dazu dauerhaft unter elektrischer Spannung stehen zu müssen. Auch kann die mittlere über die Lebensdauer anliegende elektrische Spannung an den Piezo-Linearantrieben klein gewählt werden, ohne deren Funktionsweise groß zu beeinträchtigen. Auch dies wirkt sich sehr vorteilhaft auf die Lebensdauer und die Langzeitzuverlässigkeit aus.

Für den Transport ist es darüber hinaus von Vorteil, dass der Piezo-Linearantrieb selbsthemmend ausgebildet sein kann und gemäß den später noch folgenden Anwendungsbeispielen auch ausgebildet ist, also ohne anliegende Spannung seine Position halten kann.

Die oben angeführten Eigenschaften des Piezo-Linearantriebes erfüllen in idealer Weise die Anforderungen, welche für die Manipulationsaufgaben in einer Projektionsbelichtungsanlage für die Mikrolithographie erfüllt sein müssen. Dabei sind diese Anforderungen unabhängig von der eigentlichen Manipulationsaufgabe und der damit verbundenen Verfahrrichtung im Kern immer die selben. Der erfindungsgemäße Einsatz des Piezo-Linearantriebes erschließt damit Vorteile hinsichtlich sämtlicher oben angegeben Anforderungen in praktisch allen Manipulationsaufgaben, welche in einer derartigen Abbildungseinrichtung auftreten können, insbesondere hinsichtlich der Manipulation von optischen Elementen in den drei orthogonalen x-, y- und z-Richtungen sowie hinsichtlich Kippungen bzw. Rotationen um diese Richtungen.

Vorteilhafte Weiterbildungen und Ausgestaltungen der Erfindung ergeben sich aus den restlichen Unteransprüchen und aus den nachfolgend anhand der Zeichnung prinzipmäßig beschriebenen Ausführungsbeispielen.

Es zeigt:
- Figur 1: eine Prinzipdarstellung einer Projektionsbelichtungsanlage für die Mikrolithographie, welche zur Belichtung von Strukturen auf mit photosensitiven Materialien beschichtete Wafer verwendbar ist;
- Figur 2: eine prinzipmäßige Darstellung des Linearantriebs;
- Figur 3a bis Figur 3f: eine prinzipmäßige Darstellung des Funktionsprinzips des Linearantriebs gemäß Figur 2;
- Figur 4: eine prinzipmäßige Darstellung eines Manipulators zur Manipulation eines optischen Elements in Richtung seiner optischen Achse;
- Figur 5: eine Draufsicht auf den Manipulator gemäß Figur 4;
- Figur6: eine prinzipmäßige Darstellung eines Manipulators zur Manipulation eines optischen Elements in einer Ebene senkrecht zu seiner optischen Achse;
- Figur 7: eine prinzipmäßige Darstellung einer möglichen Vorrichtung zur Manipulation eines Spiegels um zwei Achsen in einer Draufsicht; und
- Figur 8: eine prinzipmäßige Schnittdarstellung gemäß der Linie VIII-VIII in Figur 7.
- Figur 9a: Darstellung eines optischen Systems mit zwei Linsen bei unkorrigierter Koma;
- Figur 9b: vergrößerter Ausschnitt der Kaustik der in Figur 9a dargestellten Koma;
- Figur 10a: Darstellung des aus Figur 9a bekannten optischen Systems bei annähernd korrigierter Koma; und
- Figur 10b: vergrößerter Ausschnitt der Kaustik der in Figur 10a dargestellte annähernd korrigierter Koma.

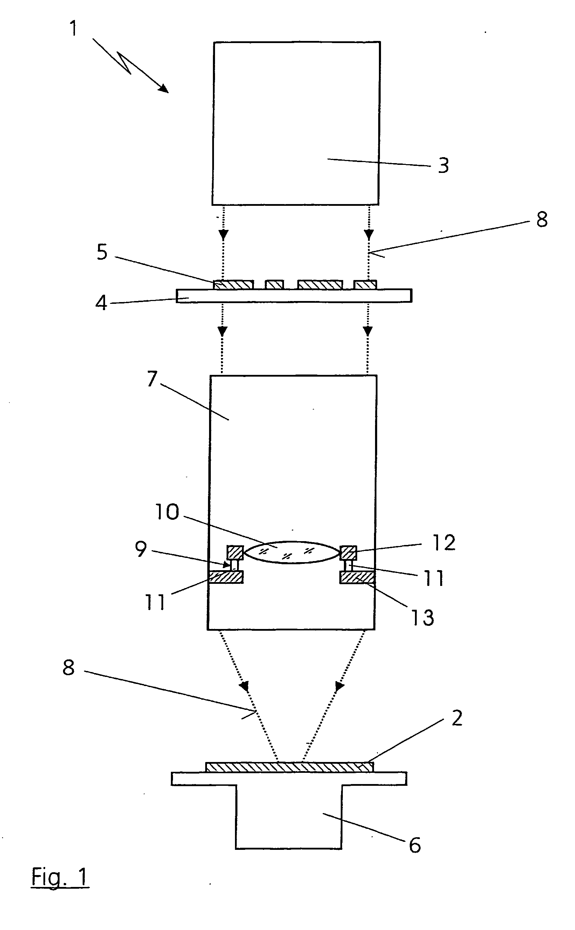

In Figur 1 ist eine Projektionsbelichtungsanlage 1 für die Mikrolithographie dargestellt. Diese dient zur Belichtung von Strukturen auf mit photosensitiven Materialien beschichtetem Substrat, welches im allgemeinen überwiegend aus Silizium besteht und als ein Wafer 2 bezeichnet wird, zur Herstellung von Halbleiterbauelementen, wie z.B. Computerchips.

Die Projektionsbelichtungsanlage 1 besteht dabei im wesentlichen aus einer Beleuchtungseinrichtung 3, einer Einrichtung 4 zur Aufnahme und exakten Positionierung einer mit einer gitterartigen Struktur versehenen Maske, ein sogenanntes Reticle 5, durch welche die späteren Strukturen auf den Wafer 2 bestimmt werden, einer Einrichtung 6 zur Halterung, Fortbewegung und exakten Positionierung eben dieses Wafers 2 und einer Abbildungseinrichtung 7.

Das grundsätzliche Funktionsprinzip sieht dabei vor, dass die in das Reticle 5 eingebrachten Strukturen auf den Wafer 2 belichtet werden, insbesondere mit einer Verkleinerung der Strukturen auf ein Drittel oder weniger der ursprünglichen Größe. Die an die Projektionsbelichtungsanlage 1, insbesondere an die Abbildungseinrichtung 7, zu stellenden Anforderungen hinsichtlich der Auflösungen liegen dabei im Sub-µm-Bereich.

Nach einer erfolgten Belichtung wird der Wafer 2 weiterbewegt, so dass auf dem selben Wafer 2 eine Vielzahl von einzelnen Feldern, jeweils mit der durch das Reticle 5 vorgegebenen Struktur, belichtet wird. Wenn die gesamte Fläche des Wafers 2 belichtet ist, wird dieser aus der Projektionsbelichtungsanlage 1 entnommen und einer Mehrzahl chemischer Behandlungsschritte, im allgemeinen einem ätzenden Abtragen von Material, unterzogen. Gegebenenfalls werden mehrere dieser Belichtungs-und Behandlungsschritte nacheinander durchlaufen, bis auf dem Wafer 2 eine Vielzahl von Computerchips entstanden ist. Aufgrund der schrittweisen Vorschubbewegung des Wafers 2 in der Projektionsbelichtungsanlage 1 wird diese häufig auch als Stepper bezeichnet. Bei Wafer-Scannern muss hingegen das Reticle 5 gegenüber dem Wafer 2 verfahren werden, um so die Reticlestruktur als ganzes abbilden zu können.

Die Beleuchtungseinrichtung 3 stellt eine für die Abbildung des Reticles 5 auf dem Wafer 2 benötigte Projektionsstrahlung, wobei hier nur ein Projektionsstrahl 8 prinzipmäßig dargestellt ist, beispielsweise Licht oder eine ähnliche elektromagnetische Strahlung, bereit. Als Quelle für diese Strahlung kann ein Laser oder dergleichen Verwendung finden. Die Strahlung wird in der Beleuchtungseinrichtung 3 über optische Elemente so geformt, dass die Projektionsstrahlung beim Auftreffen auf das Reticle 5 die gewünschten Eigenschaften hinsichtlich Telezentrie, gleichmäßige Polarisation, homogene Transmission bezüglich Feld und Winkel, kleinstmögliche Kohärenz der Strahlen zueinander und dergleichen aufweist.

Über den Projektionsstrahl 8 wird eine Bild des Reticles 5 erzeugt und von der Abbildungseinrichtung 7 entsprechend verkleinert auf den Wafer 2 übertragen, wie bereits vorstehend erläutert wurde. Die Abbildungseinrichtung 7, welche auch als Objektiv bezeichnet werden könnte, besteht dabei aus einer Vielzahl von einzelnen reflektiven, refraktiven und/oder diffraktiven optischen Elementen, wie z.B. Linsen, Spiegeln, Prismen, Planplatten und dergleichen.

Teil der Abbildungseinrichtung 7 ist außerdem wenigstens ein Manipulator 9, welcher hier nur schematisch angedeutet ist. Der Manipulator dient zur Manipulation der Position eines mit ihm in Verbindung stehenden optischen Elements 10, zur Verbesserung der erzielbaren Abbildungsqualität. Der Manipulator 9 umfasst dabei einen Linearantrieb 11, durch welchen ein fest mit dem optischen Element verbundenes, gegenüber der Abbildungseinrichtung 7 bewegliches Teil 12 des Manipulators 9, gegenüber einem fest mit der Abbildungseinrichtung 7 verbundenes Teil 13, bewegt werden kann.

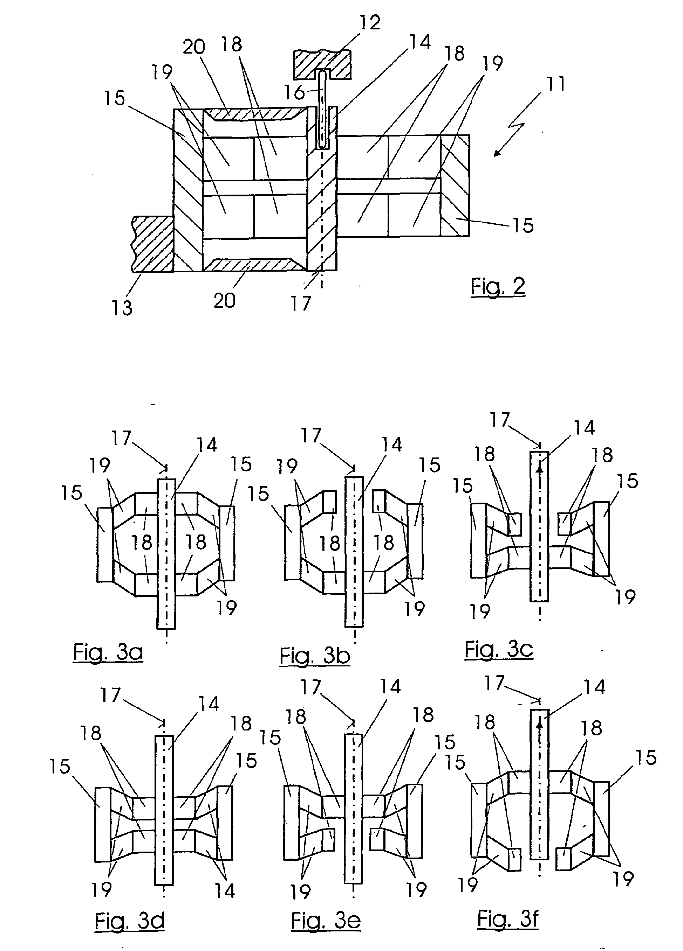

Der Linearantrieb 11, welcher in Figur 2 prinzipmäßig dargestellt ist, besteht aus einem angetriebenen Teilbereich 14 und einem nicht angetriebenen Teilbereich 15. Der nicht angetriebene Teilbereich 15 ist mit dem festen Teil 13 fest verbunden, wie dies hier prinzipmäßig angedeutet ist. Der angetriebene Teilbereich 14 ist mit dem beweglichen Teil 12 verbunden. Die Verbindung des beweglichen Teils 12 und des angetriebenen Teils 14 ist dabei über einen in einer Bohrung befindlichen Stift 16 derart realisiert, dass die Verbindung bezüglich Bewegungen senkrecht zur Bewegungsachse 17 des Linearantriebs 11 entkoppelt ist.

Die Verbindung des angetriebenen Teilbereichs 14 und des nicht angetriebenen Teilbereichs 15 erfolgt bei dem Linearantrieb 11 in der hier dargestellten Ausführungsform über acht verschiedene Funktionselemente, von denen zumindest vier zeitweise die beiden Teilbereiche 14, 15 durch Reibschluss miteinander verbinden. Jeweils vier der Funktionselemente sind so ausgebildet, dass sie eine Wirkungsrichtung senkrecht zur Bewegungsachse 17 aufweisen. Diese Funktionselemente sind in Figur 2 mit dem Bezugszeichen 18 gekennzeichnet. Zwischen diesen Funktionselementen 18 und dem nicht angetriebenen Teilbereich 15 befinden sich weitere Funktionselemente 19, deren Wirkungsrichtung in Richtung der Bewegungsachse 17 verläuft. Diese sind mit dem Bezugszeichen 19 gekennzeichnet.

Die Funktionselemente 18, 19 können gemäß einer besonders günstigen Ausführungsform als Piezoelemente ausgebildet sein. Die mit dem Bezugszeichen 18 bezeichneten Funktionselemente könnten dann als Hubpiezos 18 ausgebildet sein, während die mit dem Bezugszeichen 19 bezeichneten Funktionselemente als Scherpiezos 19 realisiert sind. Damit ergibt sich die Möglichkeit eines Bewegungsablaufs, wie er später im Rahmen der Figur 3a bis Figur 3f noch erläutert wird.

Um eine parallele Bewegung in Richtung der Bewegungsachse 17 des angetriebenen Teilbereichs 14 gegenüber dem nicht angetriebenen Teilbereich 15 zu erreichen, kann, wie es in dem hier dargestellten Ausführungsbeispiel angedeutet ist, eine Parallelführung zwischen den beiden Teilbereichen 14, 15 vorgesehen sein. Die Parallelführung besteht gemäß der hier dargestellten Ausführungsform aus zwei Balken 20, welche jeweils über Gelenke, insbesondere über Festkörpergelenke, mit dem angetriebenen Teilbereich 14 und dem nicht angetriebenen Teilbereich 15 verbunden sind. Damit ist sichergestellt, dass der angetriebene Teilbereich 14 sich gegenüber dem nicht angetriebenen Teilbereich 15 parallel bewegt, also eine Bewegung in Richtung der Bewegungsachse 17 ausführt.

Unter Bezugnahme auf die nachfolgenden Figuren 3a bis 3f ist der Bewegungsablauf des Linearantriebs 11 nachfolgend näher erläutert.

Figur 3a zeigt den angetriebenen Teilbereich 14 und den nicht angetriebenen Teilbereich 15 zusammen mit den Funktionselementen 18, 19 in einer prinzipmäßigen Darstellung. Über die vier Hubpiezos 18 ist der angetriebene Teilbereich 14 gegenüber den nicht angetriebenen Teilbereich 15 festgeklemmt. In Figur 3b ist der nachfolgende Schritt im Bewegungsablauf dargestellt, bei dem zwei der Hubpiezos 18 geöffnet, also nicht weiter im Eingriff sind, so dass durch die beiden im Bereich der noch klemmenden Hubpiezos 18 angeordneten Scherpiezos 19, eine Bewegung des angetriebenen Teilbereichs 14 gegenüber dem nicht angetriebenen Teilbereich 15 möglich wird. Diese Bewegung ist in Figur 3c prinzipmäßig dargestellt. Figur 3d zeigt den nächsten Schritt, sofern eine sehr große Bewegung des angetriebenen Teilbereichs 14 gegenüber dem nicht angetriebenen Teilbereich 15 gewünscht wird. Durch ein erneutes Betätigen der Hubpiezos 18 wird der angetriebene Teilbereich 14 wieder sicher geklemmt. Jetzt wird die Klemmung über die beiden anderen Hubpiezos 18 gelöst, wie dies in Figur 3e zu erkennen ist. In Figur 3f ist dann der nächste Schritt dargestellt, in welchem der angetriebene Teilbereich 14 wiederum über die Betätigung der Scherpiezos 19 fortbewegt wird.

Dieser prinzipielle Bewegungsablauf lässt sich beliebig wiederholen und in beliebige Richtungen ausführen. In geklemmtem Zustand weist der Linearantrieb 11 dabei jeweils eine sehr hohe Genauigkeit der Bewegung auf, welche aus der Genauigkeit der Scherpiezos 19 herrührt. Zusätzlich zu dieser sehr hohlen Genauigkeit lässt sich über die Möglichkeit des Umgreifens mittels der Hubpiezos 18 ein sehr großer Bewegungshub (Range) realisieren, so dass sich hier ein ideales Verhältnis von Auflösung zu Bewegungshub verwirklichen lässt.

Grundsätzlich sind dabei verschiedene Arten zur Betätigung des Linearantriebs 11 in der oben beschriebenen Art denkbar. Sofern eine Selbsthemmung des Linearantriebs 11 gewünscht wird, kann dieser so ausgebildet sein, dass die Funktionselemente 18, 19 über Federmittel (hier nicht dargestellt) gegen den angetriebenen Teilbereich 14 vorgespannt werden. Damit ist sichergestellt, dass sich die Funktionselemente 18, 19 immer, also auch bei einer Nichtbetätigung, in einem reibenden Eingriff befinden und so die Position des angetriebenen Teilbereichs 14 gegenüber dem nicht angetriebenen Teilbereich 15 durch Klemmen sichern. Durch die Betätigung der Hubpiezos 18 kann diese Klemmung dann im Bereich dieser betätigten Hubpiezos 18 so weit aufgehoben werden, dass hier keine Reibverbindung zwischen dem angetriebenen Teilbereich 14 und dem nicht angetriebenen Teilbereich 15 mehr vorliegt. Die weiteren Abläufe könnten dann, wie oben bereits beschrieben, realisiert werden. Zusätzlich ist dieser Aufbau besonders günstig, da durch die auf die Piezoelemente aufbringbare Vorspannung, die Lebensdauer der piezoelektrischen Funktionselemente 18, 19 erhöht werden kann. Grundsätzlich wäre jedoch auch ein anderer Aufbau denkbar, bei welchem nur bei aktiver Bestromung der Hubpiezos 18 eine Klemmung zwischen dem angetriebenen Teilbereich 14 und dem nicht angetriebenen Teilbereich 15 realisiert ist.

Derartige Linearantriebe 11 sind nun für die im Bereich der Beschreibungseinleitung bereits genannten hohen Anforderungen an Manipulationsaufgaben im Bereich von Abbildungseinrichtungen 7 geeignet, unabhängig davon, ob es sich um eine Manipulation senkrecht zur optischen Achse, um eine Kippmanipulation oder um eine Manipulation in der Ebene senkrecht zur optischen Achse handelt. Aufgrund dieser sehr allgemeinen Anwendbarkeit der oben genannten Linearantriebe 11 mit ihrer entsprechenden Wirkung für praktisch alle Bereiche der Mikrolithographie, in denen am photolithographischen Prozess beteiligte Elemente hinsichtlich ihrer Position manipuliert werden sollen, soll in den nachfolgenden Figuren nur auf drei Beispiele prinzipmäßig eingegangen werden, ohne dass die Anwendung der Linearantriebe 11 auf diese speziellen Manipulationsaufgaben aus dem Bereich einer Abbildungseinrichtung 7 für die Mikrolithographie eingeschränkt sein soll.

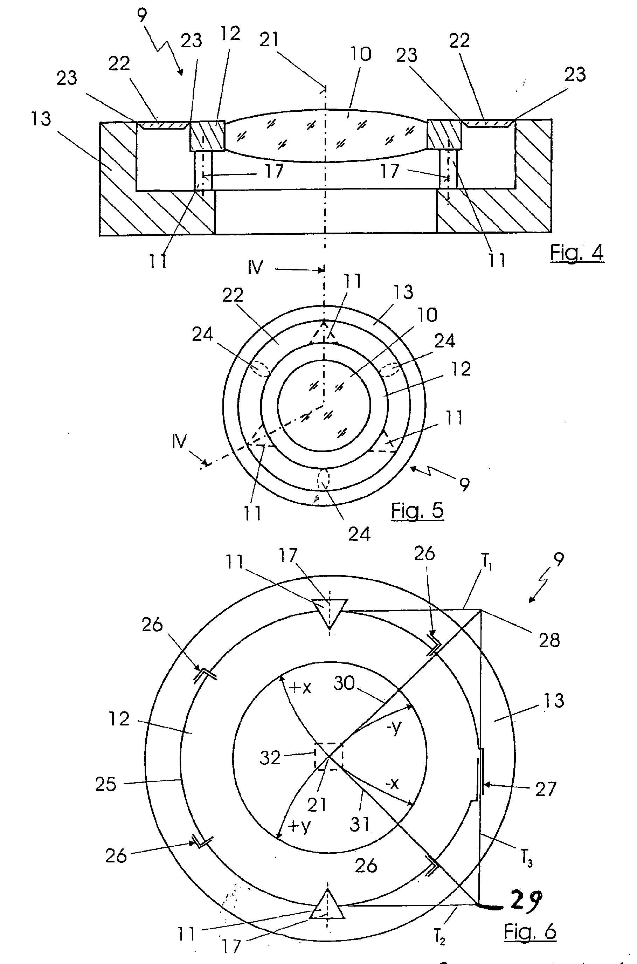

In Figur 4 ist ein Querschnitt durch den Manipulator 9 dargestellt, welcher zur Manipulation des optischen Elements 10, in dem hier gewählten Ausführungsbeispiel eine Linse 10, entlang ihrer optischen Achse 21 verwendet werden kann. Neben einer reinen Bewegung in Richtung der optischen Achse 21, welche im allgemeinen mit "z" bezeichnet wird, ist auch ein Verkippen des optischen Elements 10 denkbar.

Zur Manipulation wird das bewegliche Teil 12, hier ein beweglicher Innenring, welcher das optische Element 10 trägt, gegenüber dem festen Teil 13, hier einem festen, beispielsweise mit der Abbildungseinrichtung 7 verbundenen Außenring 13, über drei der Linearantriebe 11, von welchen hier zwei prinzipmäßig zu erkennen sind, bewegt.

Zur Führung des beweglichen Teils 12 gegenüber dem festen Teil 13 ist in dem hier dargestellten Ausführungsbeispiel eine Ringscheibe 22 vorgesehen, welche über umlaufende Festkörpergelenke 23 sowohl mit dem festen Teil 13 als auch mit dem beweglichen Teil 12 verbunden ist. Durch die Linearantriebe 11, deren Bewegungsachsen 17 wenigstens annähernd parallel zu der optischen Achse 21 verlaufen, kann das bewegliche Teil 12 gegenüber dem festen Teil 13 bewegt werden, wobei durch die Ringscheibe 22 eine Führung des beweglichen Teils 13 erreicht wird, so dass dieses in der Ebene senkrecht zu den Bewegungsachsen 17 keine Auslenkung erfährt.

Der genaue Aufbau der Führungen spielt für die hier vorliegenden Erläuterungen nur eine untergeordnete Rolle, so dass hier lediglich erwähnt werden soll, dass die Ringscheibe 22 an sich in einer vergleichsweise großen Wandstärke ausgeführt ist. In der Ringscheibe 22 kommt es so praktisch zu keinerlei Verformungen. Sämtliche Verformungen, welche im Bereich eines derartigen Führungselements auftreten, werden im Bereich der umlaufenden Festkörpergelenke 23 stattfinden. Da diese Festkörpergelenke 23 an sehr genau definierten Positionen angeordnet sind, ist das Verhalten eines derartigen Führungselements aus der Ringscheibe 22 exakt und sehr leicht vorherzubestimmen. Des weiteren lässt sich eine sehr hohe Steifigkeit des Aufbaus und damit eine sehr hohe Eigenfrequenz realisieren.

In Figur 5 ist eine Draufsicht auf den so ausgebildeten Manipulator 9 zu erkennen. Es ist wieder das feste Teil 13 und das bewegliche Teil 12 mit dem optischen Element 10 zu erkennen. Die Führung des beweglichen Teils 12 und des festen Teils 13 erfolgt über die Ringscheibe 22. Im Bereich unterhalb der Ringscheibe 22 befinden sich die drei Linearantriebe 11, welche hier in Form eines Dreiecks angedeutet sind. Zusätzlich dazu sind drei Sensoren 24 zu erkennen, welche hier prinzipmäßig mittels ovaler Strukturen angedeutet sind. Die Sensoren 24 sind in einem Winkel von jeweils 120° zueinander und gegenüber den Linearantrieben 11 in einem Winkel von jeweils 60° angeordnet. Über die Sensoren 24 lässt sich die exakte Position des beweglichen Teils 12 gegenüber dem festen Teil 13 erfassen. Die Sensoren 24 können beispielsweise als optische Sensoren 24 ausgebildet sein, welche eine Veränderung der Position entweder inkrementell oder absolut über einen Glasmaßstab erfassen können. Derartige Sensoren 24 sind handelsübliche Bauteile, weshalb auf ihre Funktionsweise hier nicht näher eingegangen werden soll.

Die Kombination aus den drei Sensoren 24, den drei Linearantrieben 11 sowie der Ringscheibe 22 als Führung, erlaubt bei einem sehr steifen Aufbau des Manipulators 9 eine exakt regelbare Positionierung des optischen Elements 10 in Richtung der optischen Achse 21 und/oder eine Kippung gegenüber der optischen Achse 21. Die Position des optischen Elements 10 in der Ebene senkrecht zur optischen Achse 11 wird dabei durch die Führung sichergestellt, wodurch ein sehr steifer und hinsichtlich Schwingungen bzw. der Anregung im Bereich der Eigenfrequenz unanfälliger Aufbau entsteht.

Der Manipulator 9, welcher in der soeben beschriebenen Art und Weise aufgebaut ist, kann die sehr hohen Anforderungen, welche im Bereich der Projektionsbelichtungsanlage 1 für die Mikrolithographie und hier insbesondere in der Abbildungseinrichtung 7 auftreten, erfüllen. Die ideale Ergänzung zu einem derartigen Aufbau sind dabei die Linearantriebe 11, welche einerseits über eine sehr hohe Genauigkeit verfügen und welche andererseits einen sehr großen "Range", also die Möglichkeit eines sehr großen Bewegungshubes, erlauben. Die erforderlichen Anforderungen an die Auflösung liegen bei einem derartigen z-und/oder Kippmanipulator 9 für den Einsatz in der Mikrolithographie bei rund 0,3 bis 0,8 nm bei einem Verfahrweg von +/-80 bis 200 µm. Die zu erzielende Steifigkeit sollte dabei auf jeden Fall größer als 12-18 N/µm sein. Die notwendigen Verstellkräfte liegen dabei über 100 N, was für die Linearantriebe 11 jedoch kein Problem ist. Der Aufbau der Linearantriebe 11 muss für diesen Einsatzfall eine Selbsthemmung ermöglichen, welche in idealer Weise mit einer entsprechenden Vorspannung der Piezoelemente 18, 19 problemlos möglich ist, wie dies oben bereits beschrieben wurde. Dabei müssen durch die Selbsthemmung auch Kräfte in der Größenordnung der 6 bis 8-fachen Verstellkräfte, beispielsweise im Falle einer Schockbelastung, gehalten werden.

Alle diese Voraussetzungen werden durch die Kombination entsprechend dem oben beschriebenen Aufbau in idealer Weise erreicht.

Neben der in dem oben genannten Ausführungsbeispiel beschriebenen Linse als optisches Element 10, ist ein vergleichbarer Aufbau natürlich auch bei anderen optischen Elementen 10, beispielsweise einem Spiegel, denkbar. Bei einer etwas gröberen Auflösung und einem größeren Verfahrbereich sind bei einem derartigen Einsatzzweck im allgemeinen vergleichbare Randbedingungen gegeben. Allenfalls die erforderliche Steifigkeit muss hier noch höher sein. Verbunden mit der gröberen Auflösung von ca. 8-12 nm, lässt sich dies jedoch durch die entsprechende Auslegung der Festkörpergelenke im Bereich der Balken 20 erzielen.

Die Figur 6 zeigt in der Draufsicht eine weitere Ausführungsform für den Manipulator 9, hier zur Manipulation des optischen Elements 10 in einer Ebene senkrecht zur optischen Achse 21. Das optische Element 10, hier beispielsweise eine Linse, ist in dem Innenring, also dem beweglichen Teil 12 des Manipulators 9 über Laschen in an sich bekannter Weise deformationsentkoppelt getragen. Das feste Teil 13, hier also der Außenring, und der Innenring 12 sind in dem hier dargestellten Beispiel einstückig ausgebildet, wobei über ein System von Umfangsschlitzen 25 zwischen dem Innenring 12 und dem Außenring 13, mit dazwischenliegenden Verbindungsgliedern 26 in L-Form, eine nachgiebige Verbindung zwischen dem Innenring 12 und dem Außenring 13 geschaffen wird. Die Verbindungsglieder 26 in L-Form sind als Festkörpergelenke ausgebildet. Sie stellen neben einem Drehgelenk 27 und zweien der Linearantriebe 11, welche hier prinzipmäßig angedeutet sind, die einzige Verbindung zwischen dem Innenring 12 und dem Außenring 13 dar.

Die Umfangsschlitze 25, welche durch Trennschnitte in die einstückige Grundform eingebracht sind, werden in regelmäßigen Abständen durch zwei mit geringem Abstand nebeneinander angeordneten Trennschnitten in L-Form unterbrochen, wodurch die Verbindungsglieder 26 in Form von Stegen zwischen den L-Form-Schnitten gebildet werden. Außerdem ist das Drehgelenk 27 ebenfalls durch einen Versatz und eine Überlappung der Umfangsschlitze 25 gebildet, wobei das Drehgelenk 27 einen Steg zwischen den sich in diesem Bereich überlappenden Umfangsschlitzen 25 aufweist. Statt der hier dargestellten Einstückigkeit von Innenring 12 und Außenring 13 kann die Verbindung jedoch auch über Gelenke in Form von eingeschweißten, geklebten oder gelöteten Bauteilen erfolgen.

An zwei gegenüberliegenden Stellen sind die Umfangsschlitze 25, unter Bildung einer größeren, hier nicht zu erkennenden Aussparung zwischen dem Außenring 13 und dem Innenring 12, unterbrochen. In den beiden Aussparungen ist jeweils einer der Linearantriebe 11 angeordnet. Dabei ist jeweils der angetriebene Teilbereich 14 mit dem Außenring 13 und der nicht angetriebene Teilbereich 15 mit dem Innenring 12 verbunden. Dieser Aufbau, welcher in der prinzipmäßigen Darstellung gemäß Figur 6 nicht im Detail zu erkennen ist, kann ohne die Funktionsweise des Manipulators 9 zu verändern, auch genau umgekehrt ausgeführt sein. Der Manipulator 9 ist als kraftfluß- und sicherheitsoptimierte Konstruktion ausgebildet.

Um nun eine gewünschte und vorbestimmte Verschiebung des Innenringes 12 gegenüber dem Außenring 13 in der x-/y-Ebene zu erreichen, sind die nachfolgenden Bedingungen bzw. Zuordnungen einzuhalten:

Das Drehgelenk 27 ist derart zwischen den beiden Angriffspunkten der Linearantriebe 11 zur Verschiebung des Innenrings 12 anzuordnen, dass sich die Tangenten T₁ und T₂ an die Angriffspunkte der Bewegungsachsen 17 der Linearantriebe 11 mit der an das Drehgelenk 27 angelegten Tangente T₃ schneiden. Die beiden Schnittpunkte bilden dabei zum einen einen Drehpol 28 für den einen der Linearantriebe 11 zur Verschiebung des Innenrings 12 in x-Richtung und zum anderen einen Drehpol 29 zur Verschiebung des Innenringes 12 in y-Richtung durch den anderen der Linearantriebe 11. Gleichzeitig ist dafür zu sorgen, dass die beiden Radialen 30 und 31 von dem Drehpol 28 bzw. dem Drehpol 29 zum Mittelpunkt bzw. zur optischen Achse 21 senkrecht aufeinander stehen. Die beiden Radialen 30 und 31 bilden somit, zumindest in einem kleinen Bereich 32 (siehe gestrichelte Darstellung in Figur 6) um die optische Achse 21, die beiden Verstellachsen, wobei die Radiale 31 die x-Achse und die Radiale 30 die y-Achse definiert.

Bei einer Betätigung des ersten Linearantriebs 11 dreht sich somit der Innenring 12 um den Drehpol 28, bei einer Verstellung des zweiten Linearantriebs 11 dreht sich der Innenring 12 um den Drehpol 29. Dies bedeutet, dass sich genaugenommen keine lineare x- bzw. y-Bewegung ergeben würde, da aber die Radien der Radialen 30 und 31 wesentlich größer sind als die vorgesehene Verstellbewegung, ergibt sich in dem bereits oben erwähnten Bereich 32, welche einem Verfahrfeld des Innenrings 12 entspricht, eine quasi lineare Bewegung in der x-y-Ebene. Zur Rückstellung von Verstellbewegungen und zur Erhöhung der Steifigkeiten für Zusatz- und Sonderlasten, können gegebenenfalls jeweils am Innenring 12 Blattfedern (nicht dargestellt) angreifen, die sich mit ihren anderen Enden an dem Außenring 13 abstützen.

Durch die Anordnung und Ausgestaltung der Umfangsschlitze 25 und der Verbindungsglieder 26 ergibt sich eine hohe Elastizität in der Ebene (x-y-Ebene) senkrecht zur optischen Achse 21 (z-Achse). Darüber hinaus ist eine hohe Steifigkeit in z-Richtung gegeben. Dies beruht unter anderem auf der L-Form der Verbindungsglieder 26, welche in z-Richtung eine entsprechende Länge besitzen können und dementsprechend eine hohe Steifigkeit in z-Richtung gewährleisten. Ebenso wie die Verbindungsglieder 26 stellt das Drehgelenk 27 bei dem Ausführungsbeispiel ein Festkörpergelenk dar. Selbstverständlich sind jedoch auch noch andere Gelenkarten zur Realisierung einer Verschiebung des Innenringes 12 gegenüber dem Außenring 13 möglich. Insbesondere wäre hier auch der Einsatz eines dritten Linearantriebs 11 an der Stelle des Drehgelenks denkbar. Die Winkellage der beiden Achsen x und y in der durch sie aufgespannten Ebene ließe sich damit variieren.

Falls keine rechtwinklige Verfahrbarkeit gewünscht wird, können die vorstehend genannten Zuordnungen der Drehpole 28, 29 und des Drehgelenkes 27 bzw. gegebenenfalls eines dritten Linearantriebs 11 auch anders getroffen werden.

Der Manipulator 9, welcher in der oben beschriebenen Art und Weise aufgebaut ist, kann die sehr hohen Anforderungen, welche im Bereich der Projektionsbelichtungsanlage 1 für die Mikrolithographie und hier insbesondere in der Abbildungseinrichtung 7 auftreten, erfüllen. Die ideale Ergänzung zu einem derartigen Aufbau sind dabei die Linearantriebe 11, welche einerseits über eine sehr hohe Genauigkeit verfügen und welche andererseits einen sehr großen "Range", also die Möglichkeit eines sehr großen Bewegungshubes erlauben. Die erforderlichen Anforderungen an die Auflösung liegen bei einem derartigen x/y-Manipulator 9 für den Einsatz in der Mikrolithographie bei rund 15 bis 25 nm bei einem Verfahrweg von +/- 1 bis 2 mm. Die zu erzielende Steifigkeit sollte dabei auf jeden Fall größer als 5 N/µm sein. Die notwendigen Verstellkräfte liegen dabei über 30 N, was für die Linearantriebe 11 jedoch kein Problem ist. Der Aufbau der Linearantriebe 11 muss für diesen Einsatzfall eine Selbsthemmung ermöglichen, welche in idealer Weise mit einer entsprechenden Vorspannung der Piezoelemente 18, 19 problemlos möglich ist, wie dies oben bereits beschrieben wurde. Dabei müssen durch die Selbsthemmung auch Kräfte in der Größenordnung der 6 bis 8-fachen Verstellkräfte, beispielsweise im Falle einer Schockbelastung, gehalten werden.

Alle diese Voraussetzungen werden durch die Kombination entsprechend dem oben beschriebenen Aufbau in idealer Weise erreicht.

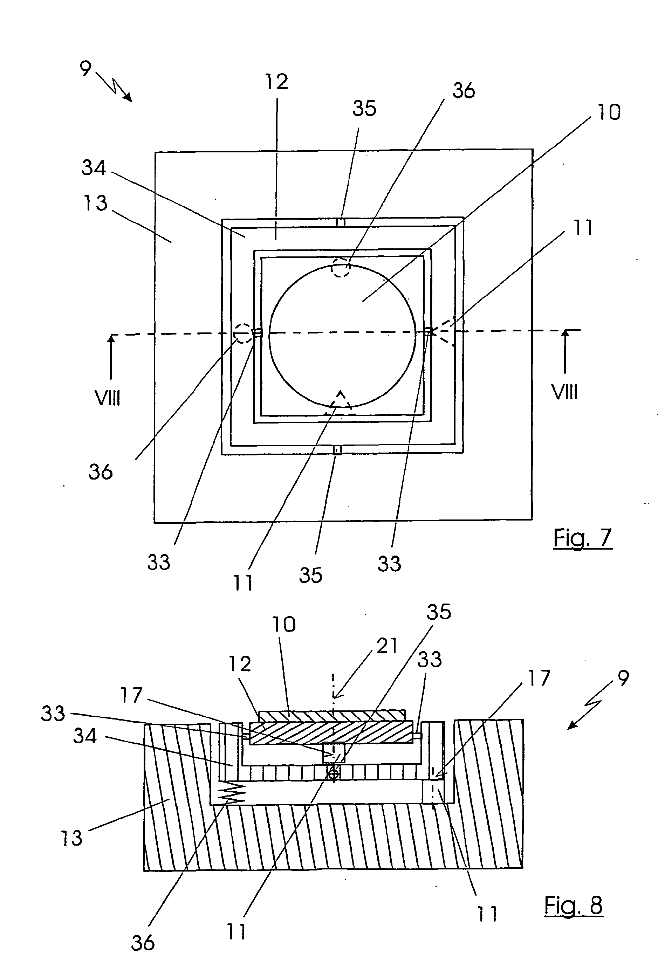

In Figur 7 ist nun ein weiterer Manipulator 9 beschrieben, welcher zur Manipulation des optischen Elements 10, in dem hier vorliegenden Fall eines Spiegels, dient. Der Aufbau des Manipulators 9 ist dabei sehr stark auf die Grundprinzipien vereinfacht und beinhaltet in dem hier dargestellten Ausführungsbeispiel eine kardanische Aufhängung des optischen Elements 10. Die kardanische Aufhängung des optischen Elements 10 in dem Manipulator 9 soll dabei nur als prinzipmäßiges Beispiel für alle Arten von Manipulatoren 9 dienen, bei denen durch die Linearantriebe 11 eine Bewegung des optischen Elements um einen festen Lagerpunkt, im allgemeinen also eine Kippung des optischen Elements 10, erfolgt.

Außerdem kann das optische Element 10 neben dem hier dargestellten Planspiegel auch ein Konkavspiegel, ein Prisma, ein Strahlteilerwürfel oder dergleichen sein, dessen Manipulation, insbesondere Kippmanipulation, für die Optimierung der Funktionsweise der Abbildungseinrichtung 7 der Projektionsbelichtungsanlage 1 erwünscht ist.

Der Manipulator 9 gemäß dem in Figur 7 und Figur 8 dargestellten Ausführungsbeispiel ist dabei so aufgebaut, dass das optische Element 10 fest mit dem beweglichen Teil 12 verbunden ist, welches wiederum über Lager- bzw. Gelenkpunkte 33 mit einem beweglichen Zwischenrahmen 34 verbunden ist. Dieser Zwischenrahmen 34 ist über zwei weitere Lager- bzw. Gelenkpunkte 35 mit dem festen Teil 13 des Manipulators 9 verbunden. Durch die aus Figur 7 ersichtliche senkrechte Anordnung der Verbindungslinien der jeweiligen Lagerpunkte 33, 35 zueinander ergibt sich eine an sich bekannte kardanische Aufhängung, welche eine Verkippung des optischen Elements 10 hinsichtlich der in Figur 8 erkennbaren optischen Achse 21 erlaubt. Die erforderlichen Linearantriebe 11 sind in Figur 7 dabei über die Dreiecke prinzipmäßig angedeutet, in ähnlicher Weise, wie dies bei den vorgehenden Figuren bereits geschehen ist.

In dem prinzipmäßigen Querschnitt gemäß Figur 8 sind die Linearantriebe 11 mit ihren Bewegungsachsen 17 nochmals näher dargestellt. Es ist erkennbar, dass der bewegliche Zwischenrahmen 34 über einen der Linearantriebe um die durch die Lagerpunkte 35 gebildete Drehachse manipulierbar ist. In dem hier prinzipmäßig dargestellten Ausführungsbeispiel ist dabei eine Federeinrichtung 36 angedeutet, welche den Zwischenrahmen 34 gegen den Linearantrieb 11 drückt und so eine fortwährende Rückstellung und eine spielfreie Verbindung zwischen dem Linearantrieb 11 und dem Zwischenrahmen 34 erlaubt. Der außerdem erkennbare Linearantrieb 11 zwischen dem Zwischenrahmen 34 und dem beweglichen Teil 12 funktioniert in analoger Weise. Selbstverständlich wäre es auch denkbar, die Rückstellkraft durch andere Mittel zu realisieren. Bei einer außermittigen Anordnung der Drehachse könnte z.B. die Schwerkraft zur Rückstellung genutzt werden.

Der durch die Figuren 7 und 8 beschriebene Aufbau soll dabei die Möglichkeiten des Einsatzes der Linearantriebe 11 nur prinzipmäßig andeuten, es sind selbstverständlich auch jegliche andere Aufbauten denkbar, bei denen entweder einer oder mehrere der Linearantriebe 11 als Lagerpunkte dienen, wie dies bei den vorhergehenden Figuren beschrieben wurde, oder bei welchen durch die Linearantriebe 11 eine Manipulation des optischen Elements 10 um einen oder mehrere feste Drehpunkte bzw. Lagerpunkte 33, 35 erfolgt.

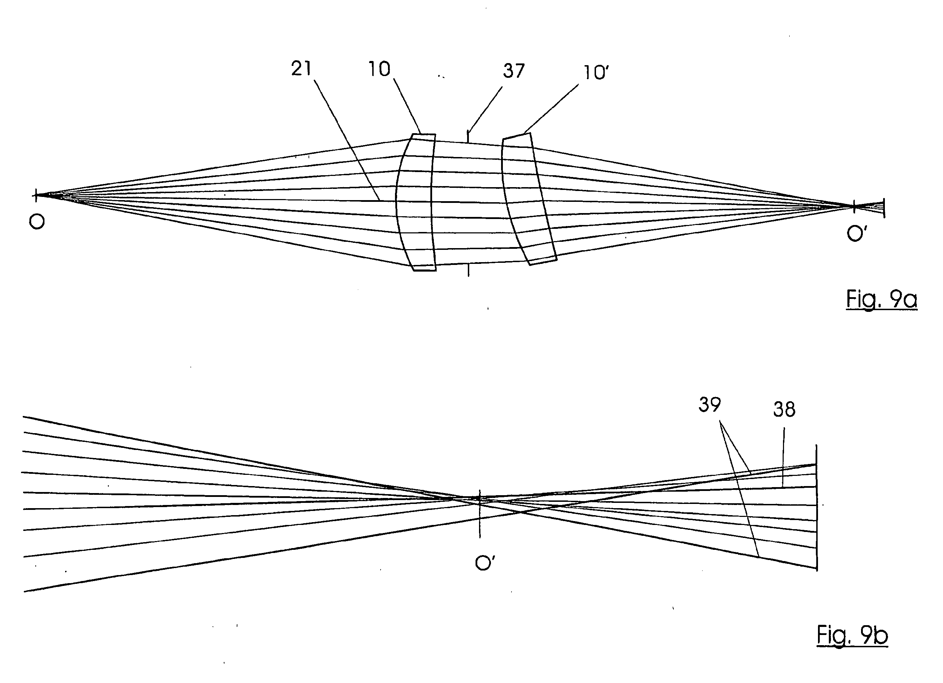

Die nachfolgenden Figuren 9a bis 10b beschreiben eine weitere Möglichkeit, um eine noch höhere Abbildungsgüte im Bereich der Abbildungseinrichtung 7 zu erreichen.

Eine vom Erfinder durchgeführte Analyse der Bildfehler durch eine Linsenerwärmung ergab, dass bei einem optischen System mit außeraxialem Feld nach den rotationssymmetrischen Fehlern, wie beispielsweise Bildfeldwölbung oder Astigmatismus mit quadratischem Feldverlauf, nicht die zweiwelligen Bildfehler, wie anamorphotische Verzeichnung, den größten Teil der Fehler liefern, sondern die einwelligen Bildfehler, beispielsweise die sagittale und tangentiale Verzeichnung und die konstante Koma. Die nachfolgenden Ausführungen beziehen sich auf die Koma.

Figur 9a zeigt ein optisches System, welches aus zwei Linsen 10 und 10' gebildet ist. Von einem Objektpunkt O aus ist der Strahlengang durch die Linsen 10 und 10' dargestellt. Eine Blende 37 ist zur Begrenzung des Lichtbündels vorgesehen. Die Linse 10' ist in diesem Ausführungsbeispiel um ca. 12° um eine Achse senkrecht zur optischen Achse 21 gekippt. Nach Durchtritt der Lichtstrahlen durch die beiden Linsen 10 und 10' sollten die Strahlen sich wieder in einem Bildpunkt O' schneiden. Die Kippung der Linse 10' induziert neben anderen Bildfehlern Koma für den Achspunkt O'.

Eine vergrößerte Darstellung der Kaustik um den Bildpunkt O' ist in Figur 9b dargestellt. Hier ist nun deutlich zu erkennen, dass eine punktförmige Abbildung des Objektpunktes O durch die beiden Linsen 10 und 10' bei Kippung der Linse 10' nicht erfolgen kann. Ein Hauptstrahl 38 wie auch Randstrahlen 39 treffen sich nicht in dem Brennpunkt bzw. Bildpunkt O'. Somit entsteht eine kometenschweifähnliche, asymmetrische und unscharfe Abbildung des Objektpunktes O', die auch als Koma bezeichnet wird.

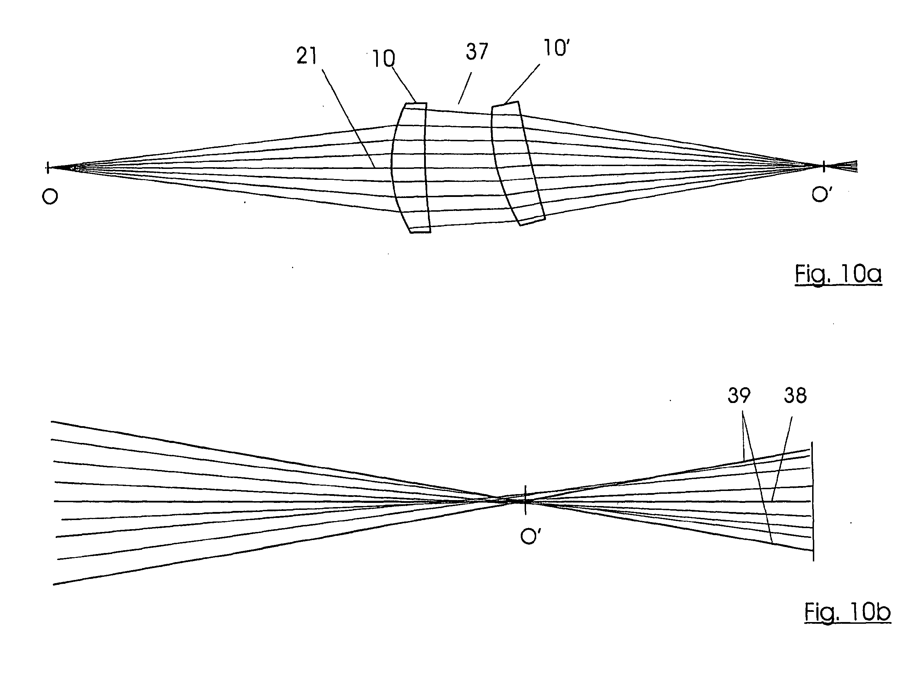

Um diesen Abbildungsfehler, wie auch die transversale Verzeichnung, zu korrigieren, ist es nun möglich, die kippmöglichkeit des erfindungsgemäßen neuentwickelten Z-Manipulators 9 zu nutzen. In Figur 10a ist dies realisiert, wobei die Linse 10 hier als Z-Manipulator ausgeführt sein soll. Zur vereinfachten Darstellung des Strahlenverlaufes wurde auf eine Darstellung des Z-Manipulators 9 in Verbindung mit der Linse 10 in diesem Ausführungsbeispiel verzichtet. Die Linse 10 ist jetzt um 0,75° gekippt. Diese Ausführung des optischen Systems kompensiert die durch die Kippung von der Linse 10' induzierte Koma auf der optischen Achse 21 in hohem Maße, wie dies in Figur 10b dargestellt ist. Die vergrößerte Kaustik laut Figur 10b weist eine nahezu korrigierte Koma nach, da der Hauptstrahl 38 und die Randstrahlen 39 sich im Bildpunkt O' schneiden. Wie für dieses System zu erwarten, treten durch die starke Verkippung der beiden Linsen 10 und 10' andere Bildfehler auf. Dies kann aber vermieden werden, durch zuvor durchgeführte Simulationsrechnungen mit Optikrechenprogrammen.

Speziell Bildfehler aufgrund von asymmetrischer Linsenerwärmung, wie die konstante Koma oder die transversale Verzeichnung, können nun durch das Verschieben von Linsen 10 senkrecht zur optischen Achse 21 oder durch das Kippen von Linsen 10 korrigiert werden.

Die zu manipulierenden Linsen sind spezifisch für ein bestimmtes Design je nach Anwendungszweck bestimmt. Bei Durchführung einer Sensitivitätsanalyse und anhand ihrer Ergebnisse können Linsen ausgewählt werden, die sich sowohl als Z-Manipulatoren 9 als auch zur Korrektur der einwelligen Fehler (Koma, Verzeichnung) durch Kippung eignen. Ihr Einsatz führt zu einer deutlich verbesserten Abbildungsqualität.

Der erfindungsgemäße Z-Manipulator 9 ermöglicht zusätzlich die Korrektur von Fehlern, die durch das nicht perfekte Arbeiten der herkömmlichen Manipulatoren unbeabsichtigt ins System eingeführt werden.

Somit können nun ebenfalls mit diesem Manipulatortyp 9 auch einwellige Bildfehler korrigiert werden. Die Manipulationen der Linsen 10 kann einzeln oder in Kombination, durch z-Verschiebung der Linsen 10 entlang der optischen Achse 21 oder durch Kippung der Linsen 10, erfolgen. Somit können nun auch asymmetrische Bildfehler, die durch Linsenerwärmung hervorgerufen werden, korrigiert werden.

## Patentansprüche

1. Abbildungseinrichtung (7) in einer Projektionsbelichtungsanlage (1) für die Mikrolithographie mit wenigstens einem optischen Element (10) und wenigstens einem einen Linearantrieb (11) aufweisenden Manipulator (9) zur Manipulation der Position des optischen Elements (10), wobei der Linearantrieb (11) einen angetriebenen Teilbereich (14) und einen nicht angetriebenen Teilbereich (15) aufweist, welche relativ zueinander in Richtung einer Bewegungsachse (17) beweglich sind, wobei die Teilbereiche (14,15) über Funktionselemente (18) mit einer Wirkungsrichtung wenigstens annähernd senkrecht zur Bewegungsachse (17) und über Funktionselemente (19) mit einer Wirkungsrichtung wenigstens annähernd parallel zur Bewegungsachse (17) zumindest zeitweise miteinander verbunden sind, und wobei das optische Element (10) fest mit einem beweglichen Teil (12) verbunden ist, welches über Führungselemente (20,22,26, 27,33,34,35) mit einem festen Teil (13) verbunden ist, welches fest mit der Abbildungseinrichtung (7) verbunden ist, wobei das bewegliche Teil (12) dem festen Teil (13) verbunden ist und die Funktionselemente (18,19) über Federmittel gegen den angetriebenen Teilbereich (14) vorgespannt werden, **dadurch gekennzeichnet, dass** mindestens eines der Führungselemente (22, 26, 27, 33, 34, 35) das bewegliche Teil (12) mit dem festen Teil (13) unmittelbar verbindet.

2. Abbildungseinrichtung nach Anspruch 1, **dadurch gekennzeichnet, dass** die Funktionselemente (18, 19) als piezoelektrische Elemente ausgebildet sind.

3. Abbildungseinrichtung (7) nach Anspruch 1 oder 2, **dadurch gekennzeichnet, dass** die beiden Teilbereiche (14,15) über Balken (20) als Führungselemente miteinander verbunden sind.

4. Abbildungseinrichtung (7) nach einem der Ansprüche 1 bis 3, **dadurch gekennzeichnet, dass** der Manipulator (9) drei der Linearantriebe (11) aufweist, deren Bewegungsachsen (17) wenigstens annähernd parallel zu der optischen Achse (21) des optischen Elements (10) verlaufen, wobei die Position des optischen Elements (10) durch wenigstens drei Sensoren (24) erfasst wird, und wobei die Manipulation als reine Bewegung in Richtung der optischen Achse (21) regelbar ist.

5. Abbildungseinrichtung (7) nach einem der Ansprüche 1 bis 4, **dadurch gekennzeichnet, dass** der Manipulator (9) drei der Linearantriebe (11) aufweist, deren Bewegungsachsen (17) wenigstens annähernd parallel zu der optischen Achse (21) des optischen Elements (10) verlaufen, wobei die Position des optischen Elements (10) durch wenigstens drei Senoptischen Elements (10) durch wenigstens drei Sensoren (24) erfasst wird, und wobei die Manipulation als Kippbewegung regelbar ist.

6. Abbildungseinrichtung (7) nach einem der Ansprüche 1 bis 4, **dadurch gekennzeichnet, dass** die Manipulation (9) des optischen Elements (10) über wenigstens zwei Linearantriebe (11) erfolgt, deren Bewegungsachsen (17) in einer Ebene senkrecht zur optischen Achse (21) des optischen Elements (10) liegen, wobei die Manipulation des optischen Elements (10) in einer Ebene senkrecht zur optischen Achse (21) erfolgt.

## Claims

1. Imaging device (7) in a projection exposure facility (1) for microlithography with at least one optical element (10) and with at least one manipulator (9) exhibiting a linear drive (11) for manipulating the position of the optical element (10), wherein the linear drive (11) exhibits a driven subregion (14) and a non-driven subregion (15) which are movable relative to one another in the direction of an axis of motion (17), wherein the subregions (14, 15) are connected to one another at least intermittently via functional elements (18) with a direction of action at least approximately perpendicular to the axis of motion (17) and via functional elements (19) with a direction of action at least approximately parallel to the axis of motion (17), and wherein the optical element (10) is firmly connected to a movable member (12) which is connected via guide elements (20, 22, 26, 27, 33, 34, 35) to a fixed member (13) which is firmly connected to the imaging device (7), wherein the movable member (12) is connected to the fixed member (13) and the functional elements (18, 19) are preloaded via spring means against the driven subregion (14), **characterised in that** at least one of the guide elements (22, 26, 27, 33, 34, 35) directly connects the movable member (12) to the fixed member (13).

2. Imaging device (7) according to Claim 1, **characterised in that** the functional elements (18, 19) take the form of piezoelectric elements.

3. Imaging device (7) according to Claim 1 or 2, **characterised in that** the two subregions (14, 15) are connected to one another via beams (20) by way of guide elements.

4. Imaging device (7) according to one of Claims 1 to 3, **characterised in that** the manipulator (9) exhibits three of the linear drives (11), the axes of motion (17) of which run at least approximately parallel to the optical axis (21) of the optical element (10), wherein the position of the optical element (10) is registered by at least three sensors (24), and wherein the manipulation is capable of being regulated as pure motion in the direction of the optical axis (21).

5. Imaging device (7) according to one of Claims 1 to 4, **characterised in that** the manipulator (9) exhibits three of the linear drives (11), the axes of motion (17) of which run at least approximately parallel to the optical axis (21) of the optical element (10), wherein the position of the optical element (10) by at least three sen optical element (10) is registered by at least three sensors (24), and wherein the manipulation is capable of being regulated as tilting motion.

6. Imaging device (7) according to one of Claims 1 to 4, **characterised in that** the manipulation (9) of the optical element (10) is effected via at least two linear drives (11), the axes of motion (17) of which lie in a plane perpendicular to the optical axis (21) of the optical element (10), wherein the manipulation of the optical element (10) is effected in a plane perpendicular to the optical axis (21).

## Revendications

1. Dispositif de formation d'images (7) d'un système d'exposition par projection (1) pour la microlithographie, comprenant au moins un élément optique (10) et au moins un manipulateur (9) comportant un entraînement linéaire (11) et destiné à manipuler la position de l'élément optique(10), dans lequel l'entraînement linéaire (11) comporte une région partielle entraînée (14) et une région partielle non entraînée (15), qui sont mobiles l'une par rapport à l'autre selon la direction d'un axe de déplacement (17), les régions partielles (14, 15) étant reliées entre elles, au moins temporairement, par l'intermédiaire d'éléments fonctionnels (18) ayant une direction d'action au moins approximativement perpendiculaire à l'axe de déplacement (17) et par l'intermédiaire d'éléments fonctionnels (19) ayant une direction d'action au moins approximativement parallèle à l'axe de déplacement (17), et dans lequel l'élément optique (10) est relié rigidement à une partie mobile (12) qui est reliée par l'intermédiaire d'éléments de guidage (20, 22, 26, 27, 33, 34, 35) à une partie fixe (13) qui est reliée rigidement au dispositif de formation d'images (7), la partie mobile (12) étant reliée à la partie fixe (13) et les éléments fonctionnels (18, 19) étant précontraints contre la région partielle entraînée (14) par l'intermédiaire de moyens élastiques, **caractérisé en ce que** au moins un des éléments de guidage (22, 26, 27, 33, 34, 35) relie directement la partie mobile (12) à la partie fixe (13).

2. Dispositif de formation d'images (7) selon la revendication 1, **caractérisé en ce que** les éléments fonctionnels (18,19) sont constitués par des éléments piézoélectriques.

3. Dispositif de formation d'images (7) selon la revendication 1 ou 2, **caractérisé en ce que** les deux régions partielles (14, 15) sont reliées entre elles par des poutres (20) servant d'éléments de guidage.

4. Dispositif de formation d'images (7) selon l'une des revendications 1 à 3, **caractérisé en ce que** le manipulateur (9) comporte trois des entraînements linéaires (11) dont les axes de déplacement (17) s'étendent au moins approximativement parallèlement à l'axe optique (21) de l'élément optique (10), la position de l'élément optique (10) étant détectée par au moins trois capteurs (24), et la manipulation pouvant être commandée en tant que mouvement dans la direction de l'axe optique (21).

5. Dispositif de formation d'images (7) selon l'une des revendications 1 à 4, **caractérisé en ce que** le manipulateur (9) comporte trois des entraînements linéaires (11) dont les axes de déplacement (17) s'étendent au moins approximativement parallèlement à l'axe optique (21) de l'élément optique (10), la position de l'élément optique (10) étant détectée par au moins trois capteurs (24), et la manipulation pouvant être commandée en tant que mouvement basculant.

6. Dispositif de formation d'images (7) selon l'une des revendications 1 à 4, **caractérisé en ce que** la manipulation (9) de l'élément optique (10) s'effectue au moyen d'au moins deux entraînements linéaires (11) dont les axes de déplacement (17) sont contenus dans un plan perpendiculaire à l'axe optique (21) de l'élément optique (10), la manipulation de l'élément optique (10) s'effectuant dans un plan perpendiculaire à l'axe optique (21).
